(19) Europäisches Patentamt
European Patent Office
Office européen des brevets

(11) **EP 3 125 315 A1**

(12) **EUROPEAN PATENT APPLICATION**
published in accordance with Art. 153(4) EPC

(43) Date of publication:
**01.02.2017 Bulletin 2017/05**

(21) Application number: **15768104.0**

(22) Date of filing: **23.03.2015**

(51) Int Cl.:
*H01L 41/187* (2006.01)  *C01G 25/00* (2006.01)
*H01L 41/318* (2013.01)

(86) International application number:
**PCT/JP2015/058666**

(87) International publication number:
**WO 2015/146877 (01.10.2015 Gazette 2015/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **27.03.2014 JP 2014065632**

(71) Applicant: **Mitsubishi Materials Corporation**
**Chiyoda-ku**
**Tokyo 100-8117 (JP)**

(72) Inventors:
• **DOI, Toshihiro**
  **Naka-shi**
  **Ibaraki 311-0102 (JP)**
• **SAKURAI, Hideaki**
  **Naka-shi**
  **Ibaraki 311-0102 (JP)**
• **SOYAMA, Nobuyuki**
  **Naka-shi**
  **Ibaraki 311-0102 (JP)**

(74) Representative: **Gille Hrabal**
**Brucknerstrasse 20**
**40593 Düsseldorf (DE)**

(54) **CERIUM-DOPED PZT PIEZOELECTRIC FILM**

(57)    A Ce-doped PZT-based piezoelectric film is provided which is formed of Ce-doped composite metal oxides represented by a general formula: $Pb_zCe_xZr_yTi_{1-y}O_3$. x, y, and z in the general formula satisfy a relationship of $0.005 \leq x \leq 0.05$, a relationship of $0.40 \leq y \leq 0.55$, and a relationship of $0.95 \leq z \leq 1.15$, respectively. It is preferable that the hysteresis of the polarization quantity of the Ce-doped PZT-based piezoelectric film be shifted from the center of the hysteresis to a negative side by 4 kV/cm or more.

FIG. 1

(a) 25℃ SOL-GEL SOLUTION
(b) 75℃ GEL FILM
(c) 300℃ CALCINATED FILM
(d) 450℃ CALCINATED FILM
(e) 700℃ CRYSTALLINE FILM

ETHANOL
PZT
PROPYLENE GLYCOL
POLYVINYLPYRROLIDONE
1-OCTANOL

EP 3 125 315 A1

**Description**

TECHNICAL FIELD

The present invention relates to a Ce-doped PZT-based piezoelectric film used in a piezoelectric element, an IPD, a pyroelectric element, a gyro sensor, a vibration power generation element, or an actuator.
Priority is claimed on Japanese Patent Application No. 2014-065632, filed March 27, 2014, the content of which is incorporated herein by reference.

BACKGROUND ART

Patent Document 1 discloses a composition for forming a ferroelectric thin film for forming one kind of ferroelectric thin film selected from the group consisting of PLZT, PZT, and PT, which is a liquid composition for forming a thin film formed of a mixed composite metal oxide in which a composite metal oxide B containing Ce is mixed with a composite metal oxide A represented by a general formula $(Pb_xLa_y)(Zr_zTi_{(1-z)})O_3$. The liquid composition is a composition for forming a ferroelectric thin film formed of an organic metal compound solution in which a raw material for configuring the composite metal oxide A and a raw material for configuring the composite metal oxide B are dissolved in an organic solvent at a ratio so as to have a metal atom ratio represented by the general formula. In this composition for forming a ferroelectric thin film, x, y, and z in the general formula satisfy a relationship of $0.9 < x < 1.3$, a relationship of $0 \leq y < 0.1$, and a relationship of $0 \leq z < 0.9$, respectively.
When a ferroelectric thin film is formed using the composition for forming a ferroelectric thin film configured as described above, it is possible to obtain a ferroelectric thin film which has substantially the same dielectric constant as that of a typical ferroelectric thin film and a low leak current density and the ferroelectric thin film which is suitable for a high-capacitance density thin film capacitor is obtained by a simple method. Accordingly, in a case where substantially the same level of leak current density as that of a typical ferroelectric thin film is obtained, a thinner film can be obtained and a higher dielectric constant is obtained.
It is known that piezoelectric properties are improved by adding Nb to a PZT-based thin film represented by $PbZr_xTh_{1-x}O_3$ formed by using a sol-gel method (for example, see Non- Patent Document 1). In Non- Patent Document 1, effects exhibited when doping with Nb is performed on a {100}-oriented PZT-based thin film grown on a seed layer of $PbTiO_3$ prepared by using a chemical solution deposition (CSD) method were investigated. Specifically, effects exhibited when doping with Nb within a range of 0 atom% to 4 atom% is performed on a {100}-oriented $Pb_{1.1}Zr_{0.52}Ti_{0.48}O_3$ thin film having a thickness of 1 $\mu$m were investigated. As a result, a high degree of {100} orientation of 97% was obtained in the entire film due to the incorporation of a $Pb_{1.05}TiO_3$ thin seed layer having a thickness of several nm. In addition, maximum polarization, residual polarization, squareness, and a saturated holding force of the entire PZT-based thin film were generally decreased together with a doping level of Nb. The PZT-based thin film doped with 3% of Nb shows the highest piezoelectric constant $-e_{31.f}$ of 12.9 C/cm$^2$, which is higher than other thin films having other doping levels by 5% to 15%. Furthermore, it was found that a permittivity is not greatly affected by the doping level of Nb.

Citation List

Patent Document

[Patent Document 1] Japanese Unexamined Patent Application, First Publication No. 2010-206151 (Claim 1 and Paragraph [0022]) Non-Patent Document
[Non- Patent Document 1] Jian Zhong et al."Effect ofNb Doping on Highly[100]-Textured PZT Films Grown on CSD-Prepared PbTiO3 Seed Layers", Integrated Ferroelectrics, 130 (2011) 1-11.

DISCLOSURE OF INVENTION

Technical Problem

However, in the composition for forming a ferroelectric thin film disclosed in Patent Document 1, a piezoelectric constant of a ferroelectric thin film formed by using this composition may not be improved and a permittivity may not be decreased. In addition, in a technology for improving piezoelectric properties of a PZT-based thin film by the adding of Nb disclosed in Non- Patent Document 1, a piezoelectric constant is improved when a Nb-doped PZT thin film (PNbZT thin film) is formed by using a wet method, that is, a sol-gel solution is used in a CSD method, but a permittivity may not be decreased and the film may not be applied to a sensor or an energy harvester. In the composition for forming a ferroelectric thin film disclosed in Patent Document 1, the film may not be used as a piezoelectric body immediately after a ferroelectric thin film is formed by using this composition, and the film is used by applying a high voltage in a case of using the film as a device such as a gyro sensor. Thus, it was necessary to perform a polarization process. Even if the polarization process is performed, depolarization may occur at the time of a thermal treatment such as a reflowing process after the polarization process and stability of polarization may be decreased.

According to the present invention, a first object is to provide a Ce-doped PZT-based piezoelectric film which can improve a piezoelectric constant of a piezoelectric film and decrease a permittivity by performing the doping with Ce. According to the present invention, a second object is to provide a Ce-doped PZT-based piezoelectric film in which polarization directions are aligned immediately after the film is formed to improve stability of polarization after the film is applied to a device by controlling the doping with Ce and the film orientation, and the polarization directions are further aligned immediately after the film is formed to further improve stability of polarization by controlling the doping with Ce and the film orientation.

Solution to Problem

In a first aspect of the present invention, there is provided a Ce-doped PZT-based piezoelectric film which is formed of Ce-doped composite metal oxides represented by a general formula: $Pb_zCe_xZr_yTi_{1-y}O_3$, in which x, y, and z in the general formula satisfy a relationship of $0.005 \leq x \leq 0.05$, a relationship of $0.40 \leq y \leq 0.55$, and a relationship of $0.95 \leq z \leq 1.15$, respectively.

In a second aspect of the present invention, the PZT-based piezoelectric film according to the first aspect of the present invention, it is preferable that the hysteresis of the polarization quantity be shifted from the center of the hysteresis to a negative side by 4 kV/cm or more.

In a third aspect of the present invention, the PZT-based piezoelectric film according to the first or second aspect of the present invention, it is preferable that a (100) orientation degree obtained by X-ray diffraction be equal to or greater than 80%.

In a fourth aspect of the present invention, the PZT-based piezoelectric film according to any one of the first to third aspects of the present invention, it is preferable that a film thickness be from 1000 nm to 5000 nm.

Advantageous Effects of Invention

In the PZT-based piezoelectric film of the first aspect of the present invention, it is possible to improve a piezoelectric constant by performing doping with Ce, and thus, it is possible to obtain greater displacement and to decrease a permittivity. Accordingly, in a case of using this piezoelectric film as a sensor, the advantages are increased. This may be because the pinning of the domain is performed by doping with Ce in a film which is (100)/(001)-oriented with respect to a normal direction of a lower electrode, and polarization directions are aligned downwardly immediately after the film is formed. As a result, in the Ce-doped PZT-based piezoelectric film of the present invention, the film can be operated as a device without polarization by applying a voltage to a positive side. In a case where the Ce-doped PZT-based piezoelectric film of the present invention is used as a gyro sensor or the like, a polarization process is not necessarily performed, and thus, it is possible to decrease the number of manufacturing steps.

In the PZT-based piezoelectric film of the third aspect of the present invention, it is possible to form a piezoelectric film having further aligned polarization directions immediately after a film is formed, and to further improve stability of polarization by setting the (100) orientation degree obtained by X-ray diffraction to be equal to or greater than 80%. Specifically, by forming a Ce-doped PZT-based piezoelectric film on a LNO film in which crystal orientation is preferentially controlled to the (100) plane, by a CSD method, the orientation of this piezoelectric film is controlled to the (100) plane. Thus, it is possible to form a piezoelectric film having further aligned polarization directions immediately after a film is formed, and further improve stability of polarization.

BRIEF DESCRIPTION OF DRAWINGS

FIG. 1 is a schematic view showing a mechanism in which voids are not generated when a film is formed by using a solution of a composition for forming a Ce-doped PZT-based piezoelectric film of the embodiment of the present invention.

FIG. 2 is a schematic view showing a mechanism in which voids are generated when a film is formed by using a solution of a composition for forming a PZT-based piezoelectric film of an example of the related art.

FIG. 3 is a schematic view showing behaviors of a piezoelectric film when a voltage is applied to a Ce-doped PZT-based piezoelectric film of the embodiment of the present invention.

FIG. 4 is a diagram showing hysteresis curves of piezoelectric films of Example 15 and Comparative Example 3.

BEST MODE FOR CARRYING OUT THE INVENTION

Next, an embodiment for realizing the present invention will be described with reference to the drawings. A Ce-doped PZT-based piezoelectric film of the present invention is formed of Ce-doped composite metal oxides represented by a general formula: $Pb_zCe_xZr_yTi_{1-y}O_3$. x, y, and z in the general formula satisfy a relationship of $0.005 \leq x \leq 0.05$, a relationship of $0.40 \leq y \leq 0.55$, and a relationship of $0.95 \leq z \leq 1.15$. This Ce-doped PZT-based piezoelectric film is a piezoelectric film in which Ce elements are added to Pb-containing composite metal oxides having a perovskite structure such as lead zirconate titanate (PZT). The Ce-doped PZT-based precursor contained in a composition for forming the Ce-doped PZT-based piezoelectric film is a raw material for configuring the composite metal oxides in the formed piezoelectric film, and is contained so that each metal atom satisfies a desired metal atom ratio. Specifically, the PZT-based precursors are contained so that the metal atom ratio (Pb:Ce:Zr:Ti) in the composition satisfies (1.00 to 1.20):(0.005 to 0.05):(0.40 to 0.55):(0.60 to 0.45) and the total of metal atom ratio of Zr and Ti is 1. Here, x in the general formula is limited to be in a range of $0.005 \leq x \leq 0.05$, because, when x is less than 0.005, polarization directions of the piezoelectric film immediately after the film is formed may not be sufficiently aligned, and when x is greater than 0.05, cracks may be easily generated on the piezoelectric film. y in the general formula is limited to be in a range of $0.40 \leq y \leq 0.55$, because when y is less than 0.40, a piezoelectric constant of the piezoelectric body is not sufficiently increased, and when y is greater than 0.55, polarization directions of the piezoelectric film immediately after the film is formed are not aligned. z in the general formula is limited to be in a range of $0.95 \leq z \leq 1.15$, because when z is less than 0.95, a large amount of pyrochlore phases is contained in the film and electrical properties such as piezoelectric properties are significantly deteriorated. When z is greater than 1.15, a large amount of PbO remains in the sintered film and electrical reliability of the film is deteriorated due to an increase in leakage current, that is, an excessive amount of lead easily remains in the film and leakage properties or insulating properties are deteriorated. In addition, x, y, and z in the general formula preferably satisfy a relationship of $0.01 \leq x \leq 0.03$, a relationship of $0.50 \leq y \leq 0.52$, and a relationship of $0.99 \leq z \leq 1.05$, respectively.

The hysteresis of polarization quantity of the Ce-doped PZT-based piezoelectric film is preferably shifted from the center thereof to a negative side by 4 kV/cm or more and more preferably shifted by a range of 9 V/cm to 15 V/cm.

The center here indicates a bias 0. When absolute values of positive and negative electric fields in a graph in which an X axis indicates the electric field (kV/cm) and Y axis indicates polarization quantity ($\mu C/cm^2$) are set as $E_c^+$ and $E_c^-$, the center of hysteresis is represented by the following expression. The following deviation of hysteresis from a bias 0 of the center is set as shift of hysteresis.

$$\text{The center of hysteresis} = E_c^+ - \{(E_c^+ + E_c^-)/2\}$$

In addition, a (100) orientation degree obtained by X-ray diffraction of the Ce-doped PZT-based piezoelectric film is equal to or greater than 80% and is more preferably equal to or greater than 95%. The upper limit value of the (100) orientation degree is 100%.

A film thickness of the Ce-doped PZT-based piezoelectric film is preferably 1000 nm to 5000 nm and more preferably from 2000 nm to 3000 nm.

Here, the shift amount of hysteresis of the polarization quantity of the Ce-doped PZT-based piezoelectric film is limited to be equal to or greater than 4 kV/cm to a negative side from the center, because, when the shift amount is less than 4 kV/cm, polarization directions are not sufficiently aligned. The (100) orientation degree obtained by X-ray diffraction of the Ce-doped PZT-based piezoelectric film is limited to be equal to or greater than 80%, because, when the (100) orientation degree is less than 80%, sufficient shift of hysteresis is not observed. The film thickness of the Ce-doped PZT-based piezoelectric film is limited to be in a range of 1000 nm to 5000 nm, because, when the film thickness thereof is less than 1000 nm, sufficient piezoelectric properties are not obtained, and when the film thickness thereof is greater than 5000 nm, productivity is deteriorated.

As the Ce-doped PZT-based precursor, a compound in which organic groups are bonded with each metal atom such as Pb, Ce, Zr, and Ti through oxygen or nitrogen atoms thereof is preferably used as each metal source (Pb source, Ce source, Zr, source, and Ti source). For example, one kind or two or more kinds selected from the group consisting of metal alkoxides, a metal diol complex, a metal triol complex, a metal carboxylate, a metal β-diketonate complex, a metal β-diketoester complex, a metal β-iminoketo complex, and a metal amino complex are used. The particularly preferable compound is metal alkoxides, a partial hydrolyzate thereof, or an organic acid salt.

Specifically, examples of the Pb compound include acetic acid salt such as lead acetate: $Pb(OAc)_2$, or alkoxides such as lead diisopropoxide: $Pb(OiPr)_2$. Examples of the Ce compound include organic acid salt such as cerium 2-ethylhexanoate or cerium 2-ethylbutyrate, alkoxides such as cerium tri n-butoxide or cerium triethoxide, or a metal β-diketonate complex such as tris (acetylacetonate) cerium. Examples of the Ti compound include alkoxides such as titanium tetraethoxide: $Ti(OEt)_4$, titanium tetraisopropoxide: $Ti(OiPr)_4$, titanium tetra-n-butoxide: $Ti(OnBu)_4$, titanium tetraisobutoxide: $Ti(OiBu)_4$, titanium tetra t-butoxide: $Ti(OtBu)_4$, and titanium dimethoxy diisopropoxide: $Ti(OMe)_2(OiPr)_2$. In addition, examples of the Zr compound include the same alkoxides as those of the Ti compounds, that is, zirconium tetraethoxide: $Zr(OEt)_4$, zirconium tetraisopropoxide: $Zr(OiPr)_4$, zirconium tetra-n-butoxide: $Zr(OnBu)_4$, zirconium tetraisobutoxide: $Zr(OiBu)_4$, zirconium tetra t-butoxide: $Zr(OtBu)_4$, and zirconium dimethoxy diisopropoxide: $Zr(OMe)_2(OiPr)_2$. The metal alkoxide may be used as it is, but a partial hydrolyzate thereof may be used in order to promote decomposition.

The composition for forming the Ce-doped PZT-based piezoelectric film preferably contains a diol and polyvinylpyrrolidone or polyethylene glycol, in addition to the Ce-doped PZT-based precursors.

A diol contained in the composition is a component which is a solvent of a composition. Specific examples of diols include propylene glycol, ethylene glycol, and 1,3-propanediol. Among these, propylene glycol or ethylene glycol is particularly preferable. When the diol is set as a compulsory solvent component, it is possible to increase storage stability of a composition. Polyvinylpyrrolidone (PVP) or polyethylene glycol may be added as a crack-inhibiting material.

The composition for forming the Ce-doped PZT-based piezoelectric film may contain a linear monoalcohol. As the linear monoalcohol, a linear monoalcohol having 6 to 12 carbon atoms is particularly preferable, because affinity with the PZT-based precursor material is low and vapor pressure is low.

Examples of other solvents include carboxylic acid, alcohol (for example, ethanol or 1-butanol, or polyalcohol other than diol), ester, ketones (for example, acetone or methyl ethyl ketone), ethers (for example, dimethyl ether or diethyl ether), cycloalkanes (for example, cyclohexane or cyclohexanol), aromatics (for example, benzene, toluene, or xylene), and other tetrahydrofurans, and a mixed solvent obtained by mixing one kind or two or more kinds of these with a diol can also be used.

Specifically, as the carboxylic acid, n-butyric acid, $\alpha$-methyl butyrate, i-valeric acid, 2-ethylbutyrate, 2,2-dimethylbutyrate, 3,3-dimethylbutyrate, 2,3-dimethylbutyrate, 3-methylpentanoate, 4-methylpentanoate, 2-ethylpentanoate, 3-ethylpentanoate, 2,2-dimethylpentanoate, 3,3-dimethylpentanoate, 2,3-dimethylpentanoate, 2-ethylhexanoate, or 3-ethylhexanoate are preferably used.

As the ester, ethyl acetate, propyl acetate, n-butyl acetate, sec-butyl acetate, tert-butyl acetate, isobutyl acetate, n-amyl acetate, sec-amyl acetate, tert-amyl acetate, or isoamyl acetate is preferably used, and as alcohol, 1-propanol, 2-propanol, 1-butanol, 2-butanol, iso-butyl alcohol, 1-pentanol, 2-pentanol, 2-methyl-2-pentanol, or 2-methoxyethanol is preferably used.

In addition to the components described above, as a stabilizer, if necessary, $\beta$-diketones (for example, acetylacetone, heptafluoro butanoylpivaloyl methane, dipivaloylmethane, trifluoroacetylacetone, benzoyl acetone, and the like), $\beta$-ketone acids (for example, acetoacetic acid, propionyl acetate, benzoyl acetate, and the like), $\beta$-ketoesters (for example, lower alkylesters such as methyl, propyl, or butyl of the ketone acids described above), oxy acids (for example, lactic acid, glycolic acid, $\alpha$-oxy butyrate, salicylic acid, and the like), lower alkylesters of the oxy acids, oxyketones (for example, diacetone alcohol, acetoin, and the like), diol, triol, higher carboxylic acid, alkanolamines (for example, diethanolamine, triethanolamine, monoethanolamine, and the like), or polyamine may be added in an amount of approximately 0.2 to 3 in terms of a value of (molecular number of stabilizer)/(metal atom number). Among these, acetylacetone of $\beta$-diketones is preferable as the stabilizer.

Next, a manufacturing method the composition for forming a Ce-doped PZT-based piezoelectric film of the present invention will be described. First, the PZT-based precursors such as the Pb compound and the like described above are prepared and these are weighed to have a rate so as to have the desired metal atom ratio described above. The weighed PZT-based precursor described above and a diol are put into a reaction vessel and mixed with each other, and refluxed and reacted with each other preferably in a nitrogen atmosphere at a temperature of 130°C to 175°C for 0.5 hours to 3 hours, and thus, synthetic liquid is prepared. After refluxing, it is preferable to perform desolventizing by using a method of atmospheric distillation or vacuum distillation. In a case of adding the stabilizer such as acetylacetone, it is preferable to add these to the synthetic liquid after the desolventizing, and perform refluxing in the nitrogen atmosphere at a temperature of 130°C to 175°C for 0.5 hours to 5 hours. After that, the synthetic liquid is cooled to room temperature (approximately 25°C) by performing natural cooling at room temperature.

The linear monoalcohol is added to the cooled synthetic liquid to prepare a sol-gel solution. At this time, the concentration of the PZT-based precursor in 100 mass% of the composition is adjusted to be 17 mass% to 35 mass% in terms of an oxide concentration and the rate of diol is adjusted to be 16 mass% to 56 mass%. In addition, a solvent other than diol is preferably added to the sol-gel solution. Then, the sol-gel solution is refluxed again in a predetermined atmosphere, for example, a nitrogen atmosphere, at a temperature of 100°C to 175°C for 0.5 hours to 10 hours.

Polyvinylpyrrolidone or polyethylene glycol in which a molar ratio of the polyvinylpyrrolidone or the polyethylene glycol to 1 mole of the PZT-based precursor satisfies 0.01 moles to 0.25 moles in terms of monomers is added to the sol-gel solution, and the polyvinylpyrrolidone or the polyethylene glycol is stirred to be evenly dispersed. Accordingly, a composition for forming the Ce-doped PZT-based piezoelectric film of the present invention is obtained.

Here, 1 mole of the Ce-doped PZT-based precursor indicates that the content of $Pb_zCe_xZr_yTi_{1-y}O_3$ contained in the precursor is 1 mole.

In addition, a value in terms of monomer is a value obtained by converting a molecular weight of a monomer using the molecular weight of the monomer configuring a polymer as a reference (1 mole).

After preparing the composition, particles are removed by performing a filtering process or the like, and the number of particles having a particle size equal to or greater than 0.5 $\mu$m (particularly, equal to or greater than 0.3 $\mu$m, and more particularly, equal to or greater than 0.2 $\mu$m) is preferably equal to or less than 50 per 1 milliliter of the composition. When the number of particles in the composition having a particle size equal to or greater than 0.5 $\mu$m exceeds 50 per 1 milliliter of the composition, long-term storage stability is deteriorated. It is preferable that the number of particles in the composition having a particle size equal to or greater than 0.5 $\mu$m be as small as possible, and it is particularly preferable that the number thereof be equal to or smaller than 30 per 1 milliliter of the composition.

A state where the particles having a particle size equal to or greater than 0.2 $\mu$m in the composition are removed by performing a filtering process or the like is preferable. A light-scattering type particle counter is used in the measurement of the number of particles in the composition.

A method of processing the composition in which the number of particles is adjusted particles to be in the range described above is not particularly limited, and the following methods are used, for example. A first method is a filtering method of performing a force-feed with a syringe by using a commercially available membrane filter having a hole diameter of 0.2 $\mu$m. A second method is a pressure-filtering method performed by combining a commercially available membrane filter having a hole diameter of 0.05 $\mu$m and a pressure tank with each other. A third method is a circulating and filtering method performed by combining the filter used in the second method and a liquid-circulating bath with each other.

In any methods, particle capture rates obtained by using a filter are different depending on force-feed pressure of the composition. It is generally known that, as the pressure is reduced, the capture rate increases. Particularly, in the first method or the second method, it is preferable that the composition be caused to extremely slowly pass through the filter at low pressure in order to realize the condition in which the number of particles having a particle size equal to or greater than 0.5 $\mu$m is equal to or smaller than 50 per 1 milliliter of the composition.

Next, a method of forming the Ce-doped PZT-based piezoelectric film of the present invention will be described. This is a method of forming a piezoelectric film by using a sol-gel method and the composition for forming the Ce-doped PZT-based piezoelectric film of the present invention is used as a raw material solution.

First, the composition for forming a Ce-doped PZT-based piezoelectric film described above is coated on a substrate and a coated film (gel film) having a predetermined thickness is formed. The coating method is not particularly limited, and spin coating, dip coating, a liquid source misted chemical deposition (LSMCD) method, or an electrostatic spray method is used. As the substrate where a piezoelectric film is formed, a silicon substrate where an orientation-controlled film or a lower electrode is formed or a heat-resistant substrate such as a sapphire substrate is used. An orientation-controlled film formed on the substrate is formed by using a LNO film ($LaNiO_3$ film) in which crystalline orientation is preferentially controlled to the (100) plane. A lower electrode formed on a substrate is formed by using a material having conductivity and not reacting with a piezoelectric film, such as Pt, $TiO_x$, Ir, or Ru. For example, the lower electrode can have a double-layered structure of a $TiO_x$ film and a Pt film, in this order, from the substrate side. As a specific example of the $TiO_x$ film, a $TiO_2$ film is used. In a case of using a silicon substrate as a substrate, a $SiO_2$ film can be formed on a surface of this substrate.

After forming a coating film on a substrate, the coating film is calcinated, and then the coating film is crystallized by sintering. The calcination is performed under predetermined conditions by using a hot plate or a rapid heating process (RTA). The calcination is performed in order to remove a solvent and convert the metal compound into a composite oxide by pyrolysis or hydrolysis, and therefore, the calcination is desirably performed in air, in an oxidation atmosphere, or in an atmosphere containing water vapor. Even when the heating is performed in the air, moisture necessary for hydrolysis is sufficiently ensured by moisture in the air. Since a low-boiling-point solvent or absorbed water molecules are particularly removed before the calcinations, low-temperature heating may be performed by using a hot plate at a temperature of 70°C to 90°C for 0.5 minutes to 5 minutes.

The sintering is a step of sintering the coating film after the calcination at a temperature equal to or higher than a crystallization temperature to perform crystallization, and a piezoelectric film is obtained by performing this step. As a sintering atmosphere of this crystallization step, $O_2$, $N_2$, Ar, $N_2O$, or $H_2$, or mixed gas thereof is suitable. The sintering is performed at 600°C to 700°C for approximately 1 minute to 5 minutes. The sintering may be performed by using a rapid heating process (RTA). In a case of performing the sintering by using a rapid heating process (RTA), a rate of temperature rise thereof is preferably from 2.5°C/sec to 100°C/sec.

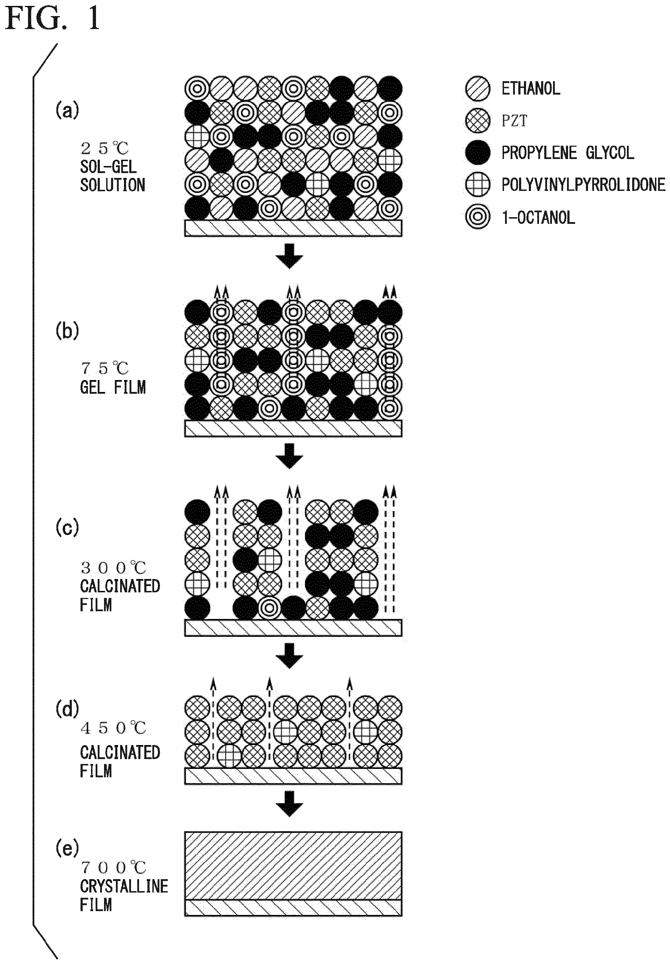

In a step of forming the Ce-doped PZT-based piezoelectric film, when the composition for forming a PZT-based piezoelectric film contains linear monoalcohol such as 1-octanol, as shown in FIG. 1(a) to FIG. 1(e), a gel film rises to the vicinity of the surface due to a capillary force and gel is dried and sintered to form a dense crystalline film without voids inside. Specifically, suitable clearances are formed in a first calcinated film, as shown in FIG. 1(c), by evaporating linear monoalcohol such as 1-octanol with a capillary force, as shown in FIG. 1(a) and FIG. 1(b). When the first calcinated film is further heated, as shown in FIG. 1(d), other solvent components (propylene glycol or polyvinylpyrrolidone) are gasified and a film in which the components are rapidly evaporated through the clearances is obtained. Accordingly, a dense crystalline film is obtained, as shown in FIG. 1(e).

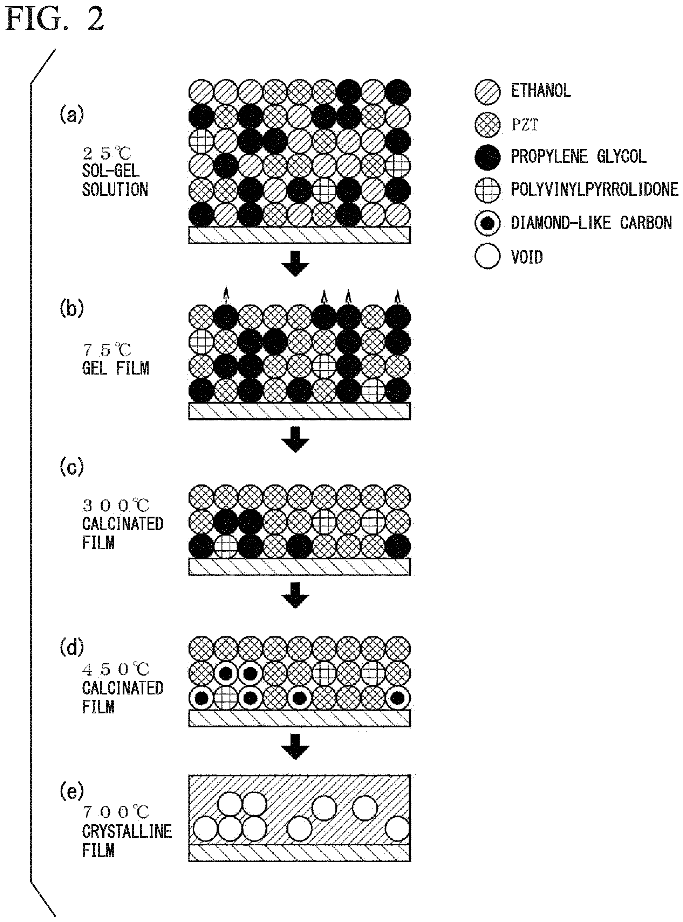

As shown in 2(a) to FIG. 2(d), in a case where a solvent such as 1-octanol which rises to the surface of the gel film and is evaporated due to a capillary force does not exist, clearances are not formed in the calcinated film, as shown in FIG. 2(a) to FIG. 2(c), and diamond-like carbon may be generated in the calcinated film (FIG. 2(d)). The diamond-like carbon causes the generation of voids (FIG. 2(e)) in a crystalline film after sintering.

By performing the steps described above, the Ce-doped PZT-based piezoelectric film is obtained. It is possible to improve a piezoelectric constant of this piezoelectric film by performing doping with Ce, and thus, it is possible to obtain greater displacement and to decrease a permittivity. Accordingly, in a case of using this piezoelectric film as a sensor, the advantages are increased. Accordingly, the Ce-doped PZT-based piezoelectric film of the present invention can be suitably used as a configuration material (electrode) of a composite electronic component such as a piezoelectric element, an IPD, a pyroelectric element, a gyro sensor, vibration power generation element, or an actuator.

By adding Ce in the vicinity of PZT, a film in which the pinning of the domain is performed, the hysteresis is shifted to a negative side from the center, and polarizations of the entire piezoelectric film are aligned downwardly immediately after a film is formed can be obtained. As a result, in the Ce-doped PZT-based piezoelectric film of the present invention, the film can be operated as a device without polarization by applying a voltage to a positive side. In a case where the Ce-doped PZT-based piezoelectric film of the present invention is used as a gyro sensor, it is not necessary to perform a polarization process, and thus, the number of manufacturing steps can be decreased. Since the Ce-doped PZT-based piezoelectric film of the present invention is formed by performing the sintering at a high temperature of 600°C to 700°C, piezoelectric properties are not lost, even when a device using the piezoelectric film is exposed to a high temperature for reflow-type soldering.

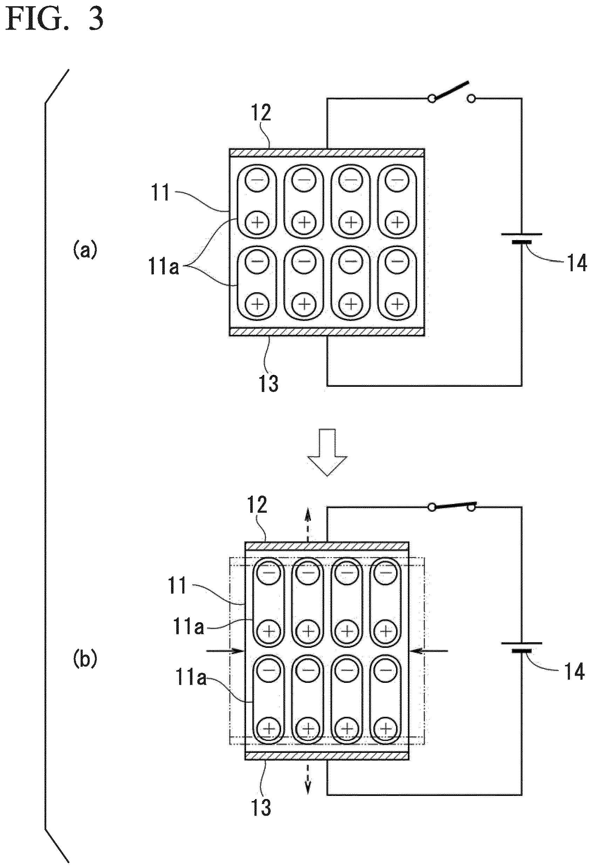

Specifically, as shown in FIG. 3, a state in which each molecule 11a in a piezoelectric film 11 is polarized is maintained, before applying a DC voltage 14 between electrodes 12 and 13 each disposed on both surfaces of the piezoelectric film 11 (FIG. 3(a)). In addition, since the Ce-doped PZT-based piezoelectric film is formed on a LNO film in which crystal orientation is preferentially controlled to the (100) plane, by a CSD method, the orientation of this piezoelectric film is controlled to the (100) plane. Thus, it is possible to form a piezoelectric film having aligned polarization directions immediately after a film is formed. As a result, it is possible to further improve stability of polarization, and thus, the piezoelectric film formed on the LNO film can be applied to a gyro sensor or the like. As shown in FIG. 3(b), when a voltage is applied between the electrodes 12 and 13 each disposed on both surfaces of the piezoelectric film 11, the piezoelectric film 11 elongates in a direction where the voltage is applied, and when this voltage is set as zero, the piezoelectric film 11 elongated in a direction where the voltage is applied is contracted and returns to the original state (FIG. 3(a)), and thus, the piezoelectric film can be used as a piezoelectric element or the like. In this embodiment, a piezoelectric film having a property of elongating in a direction where the voltage is applied is used, but a piezoelectric film having a property of elongating in a direction orthogonal to a direction where the voltage is applied may be used.

EXAMPLES

Next, examples and comparative examples of the present invention will be described in detail.

<Example 1>

First, lead acetate trihydrate (Pb source) and propylene glycol (diol) were put into a reaction vessel and refluxed in a nitrogen atmosphere at a temperature of 150°C for 1 hour, and cerium 2-ethylhexanoate (Ce source), zirconium tetrabutoxide (Zr source), titanium tetraisopropoxide (Ti source), and acetylacetone (stabilizer) were further added to this reaction vessel and refluxed and reacted with each other in the nitrogen atmosphere at a temperature of 150°C for 1 hour to prepare synthesis liquid. Here, lead acetate trihydrate (Pb source), cerium 2-ethylhexanoate (Ce source), zirconium tetrabutoxide (Zr source), and titanium tetraisopropoxide (Ti source) were weighed so that a metal atom ratio (Pb:Ce:Zr:Ti) of the Ce-doped PZT-based precursor became 1.15:0.005:0.40:0.60. In addition, propylene glycol (diol) was added to have 35 mass% with respect to 100 mass% of the Ce-doped PZT-based precursor, and acetylacetone (stabilizer) was added to have 2 moles with respect to 1 mole of the Ce-doped PZT-based precursor. Then, unnecessary solvent was removed by performing vacuum distillation so that a concentration of the Ce-doped PZT-based precursor in 100 mass% of the synthesis liquid was 35 mass% in terms of an oxide concentration. Here, the oxide concentration of the concentration of the Ce-doped PZT-based precursor in the synthesis liquid was a concentration of metal oxides in 100 mass% of the synthesis liquid which was calculated by assuming that all of the metal elements contained in the synthesis liquid were desired oxides.

Then, the synthetic liquid was cooled to 25°C by performing natural cooling at room temperature. 1-Octanol (linear monoalcohol having 8 carbon atoms) and ethanol (solvent) were added to this synthesis liquid to obtain a sol-gel solution in which a concentration of the Ce-based PZT-based precursor in 100 mass% of a sol-gel liquid was 25 mass% in terms of an oxide concentration. That is, 1-octanol (linear monoalcohol having 8 carbon atoms) and ethanol (solvent) were added to the synthesis liquid until the desired concentration was obtained. Here, the oxide concentration of the concentration of the Ce-doped PZT-based precursor in the sol-gel solution was a concentration of metal oxides in 100 mass% of the sol-gel solution which was calculated by assuming that all of the metal elements contained in the sol-gel solution were desired oxides.

Then, polyvinylpyrrolidone (PVP: k value = 30) was added to the sol-gel solution so as to obtain 0.02 moles with respect to 1 mole of the Ce-doped PZT-based precursor, and stirred at room temperature (25°C) for 24 hours to obtain a composition for forming a Ce-doped PZT-based piezoelectric film. This composition was force-fed and filtered with a syringe by using a commercially available membrane filter having a hole diameter of 0.05 $\mu$m, and accordingly, the number of particles having a particle size equal to or greater than 0.5 $\mu$m was 1 per 1 milliliter of the solution. The concentration of the Ce-doped PZT-based precursor in 100 mass% of the composition was 25 mass% in terms of an oxide concentration. In addition, 4 mass% of 1-octanol (linear monoalcohol having 8 carbon atoms) was contained in 100 mass% of the composition. Further, 30 mass% of propylene glycol (diol) was contained in 100 mass% of the composition.

The k value here was a viscosity property value relating to a molecular weight, and was a value calculated by applying a relative viscosity value (25°C) measured by using a capillary viscometer in the following Fikentscher's equation.

$$k \text{ value} = (1.5 \log\eta rel - 1)/(0.15 + 0.003c) + (300c \log\eta rel + (c + 1.5c\log\eta rel)^2)^{1/2}/(0.15c + 0.003c^2)$$

In the equation, "$\eta rel$" represents a relative viscosity of polyvinylpyrrolidone aqueous solution with respect to water and "c" represents a polyvinylpyrrolidone concentration (mass%) in the polyvinylpyrrolidone aqueous solution.

A silicon substrate, in which a $SiO_2$ film, a $TiO_2$ film, a Pt film, and an LNO film (orientation-controlled film: $LaNiO_3$ in which crystal orientation was preferentially controlled to the (100) plane) were laminated from the bottom to the top in this order, set on a spin coater. The obtained composition was added dropwise from the top of the LNO film which was an uppermost layer of the silicon substrate, and spin coating was performed at a rotation rate of 2100 rpm for 60 seconds, and accordingly, a coated film (gel film) was formed on the LNO film. A silicon substrate where this coated film (gel film) was formed was heated and held (dried) at a temperature of 65°C for 2 minutes by using a hot plate to remove a low-boiling-point solvent or water. After that, the gel film was heated and decomposed by heating and holding (calcination in a first stage) the substrate using a hot plate at 300°C for 5 minutes, and organic materials or absorbed water remaining in the gel film was removed by heating and holding (calcination in a second stage) using a hot plate at 450°C for 5 minutes. By doing so, a calcinated film (Ce-doped PZT amorphous film) having a thickness of 200 nm was obtained. A calcinated film having a thickness of 400 nm was obtained by repeating the same operation as described above twice. Then, a silicon substrate where the calcinated film having a thickness of 400 nm was formed was sintered by holding the silicon substrate in the oxygen atmosphere at 700°C for 1 minute by using a rapid heating process (RTA). A rate of temperature rise at this time was 10 °C/sec. By doing so, a Ce-doped PZT-based piezoelectric film having a thickness of 400 nm was formed on the LNO film (orientation-controlled film). A Ce-doped PZT-based piezoelectric film having a final film thickness of 2000 nm was prepared by repeating the operation described above five times. As the film thickness of the piezoelectric film, a thickness (total thickness) of a cross-section of the piezoelectric film was measured with SEM (S4300 manufactured by Hitachi, Ltd.). The metal atom ratio (Pb:Ce:Zr:Ti) of the PZT-based precursor was 1.15:0.005:0.40:0.60, but some Pb may have been evaporated and removed by performing sintering, and the metal atom ratio (Pb:Ce:Zr:Ti) of the sintered Ce-doped PZT-based piezoelectric film became 1.01:0.005:0.40:0.60 and was represented by a general formula: $Pb_{1.01}Ce_{0.005}Zr_{0.40}Ti_{0.60}O_3$.

<Example 2>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.005:0.50:0.50. The metal atom ratio (Pb:Ce:Zr:Ti) of the PZT-based precursor was 1.15:0.005:0.50:0.50, but some Pb may have been evaporated and removed by performing sintering, and the metal atom ratio (Pb:Ce:Zr:Ti) of the sintered Ce-doped PZT-based piezoelectric film became 1.01:0.005:0.50:0.50 and was represented by a general formula: $Pb_{1.01}Ce_{0.005}Zr_{0.50}Ti_{0.50}O_3$.

<Example 3>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.005:0.52:0.48. The metal atom ratio (Pb:Ce:Zr:Ti) of the PZT-based precursor was 1.15:0.005:0.52:0.48, but some Pb may have been evaporated and removed by performing sintering, and the metal atom ratio (Pb:Ce:Zr:Ti) of the sintered Ce-doped PZT-based piezoelectric film became 1.01:0.005:0.52:0.48 and was represented by a general formula: $Pb_{1.01}Ce_{0.005}Zr_{0.52}Ti_{0.48}O_3$.

<Example 4>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.005:0.55:0.45. The metal atom ratio (Pb:Ce:Zr:Ti) of the PZT-based precursor was 1.15:0.005:0.55:0.45, but some Pb may have been evaporated and removed by performing sintering, and the metal atom ratio (Pb:Ce:Zr:Ti) of the sintered Ce-doped PZT-based piezoelectric film became 1.01:0.005:0.55:0.45 and was represented by a general formula: $Pb_{1.01}Ce_{0.005}Zr_{0.55}Ti_{0.45}O_3$.

<Example 5>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.01:0.40:0.60. The metal atom ratio (Pb:Ce:Zr:Ti) of the PZT-based precursor was 1.15:0.005:0.40:0.60, but some Pb may have been evaporated and removed by performing sintering, and the metal atom ratio (Pb:Ce:Zr:Ti) of the sintered Ce-doped PZT-based piezoelectric film became 1.01:0.005:0.40:0.60 and was represented by a general formula: $Pb_{1.01}Ce_{0.005}Zr_{0.40}Ti_{0.60}O_3$.

<Example 6>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.01:0.50:0.50. The metal atom ratio (Pb:Ce:Zr:Ti) of the PZT-based precursor was 1.15:0.005:0.50:0.50, but some Pb may have been evaporated and removed by performing sintering, and the metal atom ratio (Pb:Ce:Zr:Ti) of the sintered Ce-doped PZT-based piezoelectric film became 1.01:0.005:0.50:0.50 and was represented by a general formula: $Pb_{1.01}Ce_{0.005}Zr_{0.50}Ti_{0.50}O_3$.

<Example 7>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.03:0.52:0.48. The metal atom ratio (Pb:Ce:Zr:Ti) of the PZT-based precursor was 1.15:0.005:0.52:0.48, but some Pb may have been evaporated and removed by performing sintering, and the metal atom ratio (Pb:Ce:Zr:Ti) of the sintered Ce-doped PZT-based piezoelectric film became 1.01:0.005:0.52:0.48 and was represented by a general formula: $Pb_{1.01}Ce_{0.005}Zr_{0.52}Ti_{0.48}O_3$.

<Example 8>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.05:0.55:0.45. The metal atom ratio (Pb:Ce:Zr:Ti) of the PZT-based precursor was 1.15:0.005:0.55:0.45, but some Pb may have been evaporated and removed by performing sintering, and the metal atom ratio (Pb:Ce:Zr:Ti) of the sintered Ce-doped PZT-based piezoelectric film became 1.01:0.005:0.55:0.45 and was represented by a general formula: $Pb_{1.01}Ce_{0.005}Zr_{0.55}Ti_{0.45}O_3$.

<Example 9>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.03:0.40:0.60. The metal atom ratio (Pb:Ce:Zr:Ti) of the PZT-based precursor was 1.15:0.005:0.40:0.60, but some Pb may have been evaporated and removed by performing sintering, and the metal atom ratio (Pb:Ce:Zr:Ti) of the sintered Ce-doped PZT-based piezoelectric film became 1.03:0.005:0.40:0.60 and was represented by a general formula: $Pb_{1.03}Ce_{0.005}Zr_{0.40}Ti_{0.60}O_3$.

<Example 10>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.03:0.50:0.50. The metal atom ratio (Pb:Ce:Zr:Ti) of the PZT-based precursor was 1.15:0.005:0.50:0.50, but some Pb may have been evaporated and removed by performing sintering, and the metal atom ratio (Pb:Ce:Zr:Ti) of the sintered Ce-doped PZT-based piezoelectric film became 1.03:0.005:0.50:0.50 and was represented by a general formula: $Pb_{1.03}Ce_{0.005}Zr_{0.50}Ti_{0.50}O_3$.

<Example 11 >

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.03:0.52:0.48. The metal atom ratio (Pb:Ce:Zr:Ti) of the PZT-based precursor was 1.15:0.005:0.52:0.48, but some Pb may have been evaporated and removed by performing sintering, and the metal atom ratio (Pb:Ce:Zr:Ti) of the sintered Ce-doped PZT-based piezoelectric film became 1.03:0.005:0.52:0.48 and was represented by a general formula: $Pb_{1.03}Ce_{0.005}Zr_{0.52}Ti_{0.48}O_3$.

<Example 12>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.03:0.55:0.45. The metal atom ratio (Pb:Ce:Zr:Ti) of the PZT-based precursor was 1.15:0.005:0.55:0.45, but some Pb may have been evaporated and removed by performing sintering, and the metal atom ratio (Pb:Ce:Zr:Ti) of the sintered Ce-doped PZT-based piezoelectric film became 1.03:0.005:0.55:0.45 and was represented by a general formula: $Pb_{1.03}Ce_{0.005}Zr_{0.55}Ti_{0.45}O_3$.

<Example 13>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.05:0.40:0.60. The metal atom ratio (Pb:Ce:Zr:Ti) of the PZT-based precursor was 1.15:0.005:0.40:0.60, but some Pb may have been evaporated and removed by performing sintering, and the metal atom ratio (Pb:Ce:Zr:Ti) of the sintered Ce-doped PZT-based piezoelectric film became 1.04:0.005:0.40:0.60 and was represented by a general formula: $Pb_{1.04}Ce_{0.005}Zr_{0.40}Ti_{0.60}O_3$.

<Example 14>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.05:0.50:0.50. The metal atom ratio (Pb:Ce:Zr:Ti) of the PZT-based precursor was 1.15:0.005:0.50:0.50, but some Pb may have been evaporated and removed by performing sintering, and the metal atom ratio (Pb:Ce:Zr:Ti) of the sintered Ce-doped PZT-based piezoelectric film became 1.04:0.005:0.50:0.50 and was represented by a general formula: $Pb_{1.04}Ce_{0.005}Zr_{0.50}Ti_{0.50}O_3$.

<Example 15>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.05:0.52:0.48. The metal atom ratio (Pb:Ce:Zr:Ti) of the PZT-based precursor was 1.15:0.005:0.52:0.48, but some Pb may have been evaporated and removed by performing sintering, and the metal atom ratio (Pb:Ce:Zr:Ti) of the sintered Ce-doped PZT-based piezoelectric film became 1.04:0.005:0.52:0.48 and was represented by a general formula: $Pb_{1.04}Ce_{0.005}Zr_{0.52}Ti_{0.48}O_3$.

<Example 16>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.05:0.55:0.45. The metal atom ratio (Pb:Ce:Zr:Ti) of the PZT-based precursor was 1.15:0.005:0.55:0.45, but some Pb may have been evaporated and removed by performing sintering, and the metal atom ratio (Pb:Ce:Zr:Ti) of the sintered Ce-doped PZT-based piezoelectric film became 1.04:0.005:0.55:0.45 and was represented by a general formula: $Pb_{1.04}Ce_{0.005}Zr_{0.55}Ti_{0.45}O_3$.

<Example 17>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.08:0.03:0.52:0.48, setting a mixing molar ratio of polyvinylpyrrolidone (PVP) so as to have 0.05 mole to 1 mole of the Ce-doped PZT-based precursor, and setting a mixing rate of propylene glycol (diol) as 30 mass% with respect to 100 mass% of the composition. The metal atom ratio (Pb:Ce:Zr:Ti) of the PZT-based precursor was 1.08:0.03:0.52:0.48, but some Pb may have been evaporated and removed by performing sintering, and the metal atom ratio (Pb:Ce:Zr:Ti) of the sintered Ce-doped PZT-based piezoelectric film became 0.95:0.03:0.52:0.48 and was represented by a general formula: $Pb_{0.95}Ce_{0.03}Zr_{0.52}Ti_{0.48}O_3$.

<Example 18>

A Ce-doped PZT-based piezoelectric film was formed in the same manner as in Example 17, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.12:0.03:0.52:0.48. The metal atom ratio (Pb:Ce:Zr:Ti) of the PZT-based precursor was 1.12:0.03:0.52:0.48, but some Pb may have been evaporated and removed by performing sintering, and the metal atom ratio (Pb:Ce:Zr:Ti) of the sintered Ce-doped PZT-based piezoelectric film became 0.99:0.03:0.52:0.48 and was represented by a general formula: $Pb_{0.99}Ce_{0.03}Zr_{0.52}Ti_{0.48}O_3$.

<Example 19>

A Ce-doped PZT-based piezoelectric film was formed in the same manner as in Example 17, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.18:0.03:0.52:0.48. The metal atom ratio (Pb:Ce:Zr:Ti) of the PZT-based precursor was 1.18:0.03:0.52:0.48, but some Pb may have been evaporated and removed by performing sintering, and the metal atom ratio (Pb:Ce:Zr:Ti) of the sintered Ce-doped PZT-based piezoelectric film became 1.05:0.03:0.52:0.48 and was represented by a general formula: $Pb_{1.05}Ce_{0.03}Zr_{0.52}Ti_{0.48}O_3$.

<Example 20>

A Ce-doped PZT-based piezoelectric film was formed in the same manner as in Example 17, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.18:0.03:0.52:0.48. The metal atom ratio (Pb:Ce:Zr:Ti) of the PZT-based precursor was 1.18:0.03:0.52:0.48, but some Pb may have been evaporated and removed by performing sintering, and the metal atom ratio (Pb:Ce:Zr:Ti) of the sintered Ce-doped PZT-based piezoelectric film became 1.15:0.03:0.52:0.48 and was represented by a general formula: $Pb_{1.15}Ce_{0.03}Zr_{0.52}Ti_{0.48}O_3$.

<Comparative Example 1>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.004:0.52:0.48. The metal atom ratio (Pb:Ce:Zr:Ti) of the PZT-based precursor was 1.15:0.004:0.52:0.48, but some Pb may have been evaporated and removed by performing sintering, and the metal atom ratio (Pb:Ce:Zr:Ti) of the sintered Ce-doped PZT-based piezoelectric film became 1.00:0.004:0.52:0.48 and was represented by a general formula: $PbCe_{0.004}Zr_{0.52}Ti_{0.48}O_3$.

<Comparative Example 2>

A Ce-doped PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.15:0.06:0.40:0.60. The metal atom ratio (Pb:Ce:Zr:Ti) of the PZT-based precursor was 1.15:0.06:0.40:0.60, but some Pb may have been evaporated and removed by performing sintering, and the metal atom ratio (Pb:Ce:Zr:Ti) of the sintered Ce-doped PZT-based piezoelectric film became 1.00:0.06:0.40:0.60 and was represented by a general formula: $PbCe_{0.06}Zr_{0.40}Ti_{0.60}O_3$.

<Comparative Example 3>

A PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the PZT-based precursor became 1.15:0:0.52:0.48 in which cerium 2-ethylhexanoate (Ce source) waswas not added. The metal atom ratio (Pb:Ce:Zr:Ti) of the PZT-based precursor was 1.15:0:0.52:0.48, but some Pb may have been evaporated and removed by performing sintering, and the metal atom ratio (Pb:Ce:Zr:Ti) of the sintered Ce-doped PZT-based piezoelectric film became 1.02:0:0.52:0.48 and was represented by a general formula: $Pb_{1.02}Zr_{0.52}Ti_{0.48}O_3$.

<Comparative Example 4>

A PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the PZT-based precursor became 1.15:0.03:0.38:0.62. The metal atom ratio (Pb:Ce:Zr:Ti) of the PZT-based precursor was 1.15:0.03:0.38:0.62, but some Pb may have been evaporated and removed by performing sintering, and the metal atom ratio (Pb:Ce:Zr:Ti) of the sintered Ce-doped PZT-based piezoelectric film became 1.02:0.03:0.38:0.62 and was represented by a general formula: $Pb_{1.02}Ce_{0.03}Zr_{0.38}Ti_{0.62}O_3$.

<Comparative Example 5>

A PZT-based piezoelectric film was formed in the same manner as in Example 1, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the PZT-based precursor became 1.15:0.03:0.57:0.43. The metal atom ratio (Pb:Ce:Zr:Ti) of the PZT-based precursor was 1.15:0.03:0.57:0.43, but some Pb may have been evaporated and removed by performing sintering, and the metal atom ratio (Pb:Ce:Zr:Ti) of the sintered Ce-doped PZT-based piezoelectric film became 1.02:0.03:0.57:0.43 and was represented by a general formula:

$Pb_{1.02}Ce_{0.03}Zr_{0.57}Ti_{0.43}O_3$.

<Comparative Example 6>

A Ce-doped PZT-based piezoelectric film was formed in the same manner as in Example 17, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.07:0.03:0.52:0.48. The metal atom ratio (Pb:Ce:Zr:Ti) of the PZT-based precursor was 1.07:0.03:0.52:0.48, but some Pb may have been evaporated and removed by performing sintering, and the metal atom ratio (Pb:Ce:Zr:Ti) of the sintered Ce-doped PZT-based piezoelectric film became 0.94:0.03:0.52:0.48 and was represented by a general formula: $Pb_{0.94}Ce_{0.03}Zr_{0.52}Ti_{0.48}O_3$.

<Comparative Example 7>

A Ce-doped PZT-based piezoelectric film was formed in the same manner as in Example 17, except for weighing lead acetate trihydrate (Pb source), cerium 2-ethylhexanoate (Ce source), zirconium tetrabutoxide (Zr source), and titanium tetraisopropoxide (Ti source) so that a metal atom ratio (Pb:Ce:Zr:Ti) of the Ce-doped PZT-based precursor became 1.29:0.03:0.52:0.48. The metal atom ratio (Pb:Ce:Zr:Ti) of the PZT-based precursor was 1.29:0.03:0.52:0.48, but some Pb may have been evaporated and removed by performing sintering, and the metal atom ratio (Pb:Ce:Zr:Ti) of the sintered Ce-doped PZT-based piezoelectric film became 1.16:0.03:0.52:0.48 and was represented by a general formula: $Pb_{1.16}Ce_{0.03}Zr_{0.52}Ti_{0.48}O_3$.

<Comparative Test 1 and Evaluation>

Regarding the Ce-doped PZT-based piezoelectric films formed in Examples 1 to 20 and Comparative Examples 1 to 7, a film composition, deviation of the hysteresis, an orientation degree, a piezoelectric constant $e_{31.f}$, and presence or absence of cracks were evaluated.

A film composition (atom metal ratio) of the sintered Ce-doped PZT-based piezoelectric film shown in each example was measured by X-ray fluorescence analysis using an X-ray fluorescence spectrometer(type name: Primus III+ manufactured by Rigaku Corporation).

The deviation of hysteresis of the polarization quantity of the piezoelectric film was measured by using TF-analyzer 2000 (manufactured by aixACCT Systems). Specifically, first, a pair of electrodes having a diameter of 200 $\mu$m werewere formed on both surfaces of the Ce-doped PZT-based piezoelectric film by using a sputtering method, and then the Ce-doped PZT-based piezoelectric film was subjected to the rapid heating process (RTA). Furthermore, the piezoelectric film was annealed to recover damage by maintaining in the oxygen atmosphere at 700°C for 1 minute, and a metal-insulator-metal (MIM) capacitor structure was prepared. Then, by using these as test samples, the hysteresis of the polarization quantity of the piezoelectric film was measured by applying a voltage of 25 V at a frequency of 1 kHz, and deviation of the hysteresis of the obtained polarization quantity was obtained.

An orientation degree of the Ce-doped PZT-based piezoelectric film to the (100) plane of crsytal was calculated by calculating strength of (100) plane/{strength of (100) plane + strength of (110) plane + strength of (111) plane} from a diffraction result obtained by a focusing method using an X-ray diffraction (XRD) device (type name: Empyrean manufactured by PANalytical B.V).

A piezoelectric constant $e_{31.f}$ was measured by using a piezoelectrics evaluation device (4-Point Bending System manufactured by aixACCT Systems). The above measurement was performed at a frequency of 1 kHz.

The presence or absence of cracks was determined from an SEM image obtained by imaging textures of a film front surface and a film cross-section, using a scanning electron microscope (SEM) used in the film thickness measurement described above. Here, the crack was a crack having a short diameter equal to or greater than 30 nm and a long diameter equal to or greater than 200 nm in an SEM image having a size of 26 $\mu$m x 19 $\mu$m (magnification: x 5000). The measurement was performed in three regions which were randomly selected from the piezoelectric film obtained in each of Examples and Comparative Examples. It was determined as "absence of cracks" when cracks were not observed, and it was determined as "presence of cracks" when cracks were observed. These results were shown in Table 1 and Table 2.

[Table 1]

| | Metal atom ratio in PZT-based piezoelectric film (Pb:Ce:Zr:Ti) | Deviation of P-V hysteresis (kV/cm) | Orientation degree (%) | $e_{31.f}$ (C/m$^2$) | Presence or absence of cracks |
|---|---|---|---|---|---|
| Example 1 | 1.01:0.005:0.40:0.60 | 4 | 95 | -8.2 | Absent |
| Example 2 | 1.01 :0.005:0.50:0.50 | 4 | 93 | -12.1 | Absent |
| Example 3 | 1.01:0.005:0.52:0.48 | 5 | 97 | -14.6 | Absent |
| Example 4 | 1.01:0.005:0.55:0.45 | 4 | 90 | -12.9 | Absent |
| Example 5 | 1.01:0.01:0.40:0.60 | 6 | 90 | -10.3 | Absent |
| Example 6 | 1.01:0.01:0.50:0.50 | 6 | 92 | -13.8 | Absent |
| Example 7 | 1.01:0.01:0.52:0.48 | 10 | 89 | -16.1 | Absent |
| Example 8 | 1.01:0.01:0.55:0.45 | 16 | 96 | -12.2 | Absent |
| Example 9 | 1.03:0.03:0.40:0.60 | 7 | 98 | -10.1 | Absent |
| Example 10 | 1.03:0.03:0.50:0.50 | 12 | 91 | -15.2 | Absent |
| Example 11 | 1.03:0.03:0.52:0.48 | 9 | 83 | -16.1 | Absent |
| Example 12 | 1.03:0.03:0.55:0.45 | 9 | 92 | -14.2 | Absent |
| Example 13 | 1.04:0.05:0.40:0.60 | 14 | 90 | -9.2 | Absent |
| Example 14 | 1.04:0.05:0.50:0.50 | 13 | 98 | -14.3 | Absent |
| Example 15 | 1.04:0.05:0.52:0.48 | 15 | 93 | -15.1 | Absent |
| Example 16 | 1.04:0.05:0.55:0.45 | 11 | 90 | -12.3 | Absent |
| Comparative Example 1 | 1.00:0.004:0.52:0.48 | 1 | 95 | -4.3 | Absent |
| Comparative Example 2 | 1.00:0.06:0.40:0.60 | 15 | 92 | -6.2 | Present |
| Comparative Example 3 | 1.02:0:0.52:0.48 | 0 | 92 | -0.3 | Absent |
| Comparative Example 4 | 1.02:0.03:0.38:0.62 | 8 | 92 | -3.8 | Absent |
| Comparative Example 5 | 1.02:0.03:0.57:0.43 | 6 | 93 | -5.2 | Absent |

[Table 2]

| | Metal atom ratio in PZT-based piezoelectric film (Pb:Ce:Zr:Ti) | Deviation of P-V hysteresis (kV/cm) | Orientation degree (%) | $e_{31.f}$ (C/m$^2$) | Presence or absence of cracks |
|---|---|---|---|---|---|
| Example 17 | 0.95:0.03:0.52:0.48 | 9 | 92 | -11.9 | Absent |
| Example 18 | 0.99:0.03:0.52:0.48 | 8 | 96 | -13.5 | Absent |
| Example 19 | 1.05:0.03:0.52:0.48 | 10 | 98 | -14.2 | Absent |
| Example 20 | 1.15:0.03:0.52:0.48 | 9 | 90 | -11.8 | Absent |
| Comparative Example 6 | 0.94:0.03:0.52:0.48 | 9 | 92 | -7.2 | Absent |

(continued)

|  | Metal atom ratio in PZT-based piezoelectric film (Pb:Ce:Zr:Ti) | Deviation of P-V hysteresis (kV/cm) | Orientation degree (%) | $e_{31.f}$ (C/m$^2$) | Presence or absence of cracks |
|---|---|---|---|---|---|
| Comparative Example 7 | 1.16:0.03:0.52:0.48 | 8 | 90 | - 8.0 | Absent |

As shown in Table 1, in Comparative Example 1 where the doping amount of Ce was as small as 0.004 and Comparative Example 3 where the doping with Ce was not performed, cracks were not generated on the piezoelectric film, but the deviation of P-V hysteresis was as small as 1 kV/cm and 0 kV/cm, and the absolute values of the piezoelectric constant $e_{31.f}$ were as small as 4.3 C/m$^2$ and 0.3 C/m$^2$. In Comparative Example 2 where the doping amount of Ce was as great as 0.06, the deviation of P-V hysteresis was as great as 15 kV/cm, but cracks were generated on the piezoelectric film, and the absolute value of piezoelectric constant $e_{31.f}$ was as small as 6.2 C/m$^2$. With respect to these results, in Examples 1 to 16 where the doping amount with Ce was in the appropriate range of 0.005 to 0.05, cracks were not generated, the deviation of P-V hysteresis was as great as 4 kV/cm to 16 kV/cm, and the absolute value of piezoelectric constant $e_{31.f}$ was as great as 8.2 C/m$^2$ to 16.1 C/m$^2$.

In Comparative Example 4 where the atom ratio of Zr/Ti was as small as 0.38/0.62 and Comparative Example 5 where the atom ratio of Zr/Ti was as great as 0.57/0.43, the deviation of P-V hysteresis was as great as 8 C/m$^2$ and 6 C/m$^2$ and cracks were not generated on the piezoelectric film, but the absolute values of piezoelectric constant $e_{31.f}$ were as small as 3.8 C/m$^2$ and 5.2 C/m$^2$. With respect to these results, in Examples 1 to 16 where the atom ratio of Zr/Ti was in the appropriate range of 0.40/0.60 to 0.55/0.45, cracks were not generated, the deviation of P-V hysteresis was as great as 4 kV/cm to 16 kV/cm, and the absolute value of piezoelectric constant $e_{31.f}$ was as great as 8.2 C/m$^2$ to 16.1 C/m$^2$.

As shown in Table 2, in Comparative Example 6 where the content ratio of Pb in the PZT-based piezoelectric film was as small as 0.94, an absolute value of the piezoelectric constant $e_{31.f}$ was as small as 7.2 C/m$^2$ and in Comparative Example 7 where the content ratio of Pb in the PZT-based piezoelectric film was as great as 1.16, an absolute value of the piezoelectric constant $e_{31.f}$ was as small as 8.0 C/m$^2$, whereas in Examples 17 to 20 where the content ratio of Pb in the PZT-based piezoelectric film was in the appropriate range of 0.95 to 1.15, an absolute value of the piezoelectric constant $e_{31.f}$ was as great as in a range of 11.8 C/m$^2$ to 14.2 C/m$^2$. Therefore, it was found that it was important to control the concentration of Pb in the composition so that the content ratio z of Pb in the PZT-based piezoelectric film satisfies a relationship of $0.95 \leq z \leq 1.15$.

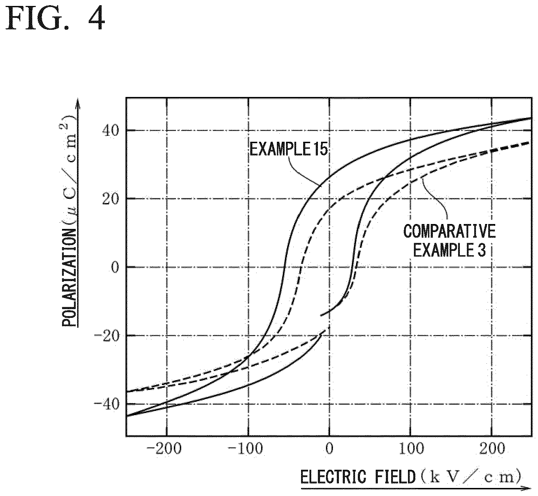

Regarding the Ce-doped PZT-based piezoelectric films formed in Example 15 and Comparative Example 3, hysteresis curves when deviation of hysteresis was measured in Comparative Test 1 were drawn in FIG. 4. As shown from the hysteresis curves drawn in FIG. 4, it was found that hysteresis of the piezoelectric film in Example 15 was shifted to the negative side, compared to hysteresis of the piezoelectric film in Comparative Example 3.

Although not shown in Tables 1 and 2, regarding the Ce-doped PZT-based piezoelectric film formed in Examples and Comparative Examples, a permittivity was measured by using TF-analyzer 2000 manufactured by aixACCT Systems. The results were as follows. Example 1: 850, Example 2: 1280, Example 3: 1300, Example 4: 1280, Example 5: 800, Example 6: 1190, Example 7: 1210, Example 8: 1190, Example 9: 720, Example 10: 1090, Example 11: 1120, Example 12: 1100, Example 13: 670, Example 14: 1010, Example 15: 1030, Example 16: 1020, Example 17: 1010, Example 18: 1100, Example 19: 1130, Example 20: 1140, Comparative Example 1: 1390, Comparative Example 2: 620, Comparative Example 3: 1420, Comparative Example 4: 680, Comparative Example 5: 1320, Comparative Example 6: 1050, Comparative Example 7: 1140. As described above, a permittivity of PZT, which was base material, was decreased by performing the doping with Ce, and a film having great advantages for use as a sensor was obtained.

Hereinabove, the preferred examples of the present invention have been described, but the present invention is not limited to these examples. Addition, omission, replacement, and other modifications of the configuration can be performed within a range not departing from a scope of the present invention. The present invention is not limited to the descriptions described above and only limited to the range of accompanied claims.

INDUSTRIAL APPLICABILITY

The Ce-doped PZT-based piezoelectric film of the present invention can be used in the manufacturing of a configuration material (electrode) of a composite electronic component such as a piezoelectric element, an IPD, a pyroelectric element, a gyro sensor, a vibration power generation element, or an actuator.

**Claims**

1. A Ce-doped PZT-based piezoelectric film formed of Ce-doped composite metal oxides represented by a general formula: $Pb_zCe_xZr_yTi_{1-y}O_3$,
   wherein x, y, and z in the general formula satisfy a relationship of $0.005 \leq x \leq 0.05$, a relationship of $0.40 \leq y \leq 0.55$, and a relationship of $0.95 \leq z \leq 1.15$, respectively.

2. The Ce-doped PZT-based piezoelectric film according to Claim 1,
   wherein the hysteresis of the polarization quantity is shifted from the center of the hysteresis to a negative side by 4 kV/cm or more.

3. The Ce-doped PZT-based piezoelectric film according to Claim 1 or 2,
   wherein a (100) orientation degree obtained by X-ray diffraction is equal to or greater than 80%.

4. The Ce-doped PZT-based piezoelectric film according to any one of Claims 1 to 3,
   wherein a film thickness is from 1000 nm to 5000 nm.

# FIG. 1

(a)

2 5℃
SOL-GEL
SOLUTION

(b)

7 5℃
GEL FILM

(c)

3 0 0℃
CALCINATED
FILM

(d)
4 5 0℃
CALCINATED
FILM

(e)
7 0 0℃
CRYSTALLINE
FILM

ETHANOL
PZT
PROPYLENE GLYCOL
POLYVINYLPYRROLIDONE
1-OCTANOL

# FIG. 2

(a) 25℃ SOL-GEL SOLUTION

(b) 75℃ GEL FILM

(c) 300℃ CALCINATED FILM

(d) 450℃ CALCINATED FILM

(e) 700℃ CRYSTALLINE FILM

Legend:
- ETHANOL
- PZT
- PROPYLENE GLYCOL
- POLYVINYLPYRROLIDONE
- DIAMOND-LIKE CARBON
- VOID

# FIG. 3

(a)

(b)

# FIG. 4

**INTERNATIONAL SEARCH REPORT**

| International application No. |
|---|
| PCT/JP2015/058666 |

A.    CLASSIFICATION OF SUBJECT MATTER
*H01L41/187*(2006.01)i, *C01G25/00*(2006.01)i, *H01L41/318*(2013.01)i

According to International Patent Classification (IPC) or to both national classification and IPC

B.    FIELDS SEARCHED

Minimum documentation searched (classification system followed by classification symbols)
H01L41/187, C01G25/00, H01L41/318

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C.    DOCUMENTS CONSIDERED TO BE RELEVANT

| Category* | Citation of document, with indication, where appropriate, of the relevant passages | Relevant to claim No. |
|---|---|---|
| X<br>Y<br>A | S.B.MAJUMDER (et al.), Effect of cerium doping on the micro-structure and electrical properties of sol-gel derived $Pb_{1.05}(Zr_{0.53-\delta}Ce_{\delta}Ti_{0.47})O_3$ ($\delta \leq 10$ at.%) thin films, Materials Science and Engineering B, 2003.02. 25, Volume 98, Issue 1, pp.25-32 | 1,4<br>3<br>2 |
| Y<br>A | JP 2012-169400 A  (Panasonic Corp.),<br>06 September 2012 (06.09.2012),<br>paragraphs [0016] to [0080]; fig. 3<br>(Family: none) | 3<br>2 |

☐    Further documents are listed in the continuation of Box C.      ☐    See patent family annex.

| | |
|---|---|
| *    Special categories of cited documents:<br>"A"    document defining the general state of the art which is not considered    to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| 20 May 2015 (20.05.15) | 09 June 2015 (09.06.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | |
| | Telephone No. |

Form PCT/ISA/210 (second sheet) (July 2009)

**EP 3 125 315 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014065632 A
- JP 2010206151 A

**Non-patent literature cited in the description**

- **JIAN ZHONG et al.** Effect ofNb Doping on Highly[100]-Textured PZT Films Grown on CSD-Prepared PbTiO3 Seed Layers. *Integrated Ferroelectrics,* 2011, vol. 130, 1-11